# EUROPEAN PATENT APPLICATION

(11) **EP 0 785 087 A1**
(43) Date of publication of application: **23.07.1997**
(21) Application number: 96200076.6
(22) Date of filing: 16.01.1996
(51) Int. Cl.: B41M 5/38, G03F 3/10, B41M 5/34

(54) **Thermal dye sublimation transfer process**

(71) Applicant: AGFA-GEVAERT naamloze vennootschap, 2640 Mortsel (BE)
(72) Inventor: Janssens, Wilhelmus, B-2640 Mortsel (BE); Vanmaele, Luc, B-2640 Mortsel (BE)

(57) **Abstract**

The present invention describes a method for reproducing an image according to thermal dye sublimation transfer printing by printing two or more color separations of said image on top of each other, said method comprising in the order given the steps of:
(i) forming a first assemblage by bringing a dye donor layer into face-to-face relationship with a receiving layer comprised on a support of a receiving element, said dye donor layer having a color and comprising a dye;
(ii) image-wise heating said first assemblage thereby transferring said dye to said receiving layer in accordance with an amount of heat supplied and rendering a first color separation of said image;
(iii) separating said dye donor layer from said receiving layer;
(iv) forming at least one other assemblage by bringing a further dye donor layer into face-to-face relationship with said receiving layer of said receiving element, said further dye donor layer having a primary color different from a color of a dye donor layer used in any other assemblage and comprising a dye;
(v) image-wise heating said other assemblage thereby transferring said dye to said receiving layer in accordance with an amount of heat supplied and rendering a further color separation of said image;
said method being characterised in that a component A and B are brought in reactive association during image-wise heating of said other assemblage, said component A and B thereby forming a color of similar hue as a previously rendered color separation of said image.

## Description

### 1. Field of the invention

The present invention relates to dye-donor elements for use according to thermal dye sublimation transfer and in particular to a method for compensating retransfer of dyes during the recording process.

### 2. Background of the invention

Thermal dye sublimation transfer or thermal dye diffusion transfer is a recording method in which a dye-donor element provided with a dye layer containing sublimable dyes having heat transferability is brought into contact with a receiver sheet or receiver element and selectivity, in accordance with a pattern information signal, is heated by means of a thermal printing head provided with a plurality of juxtaposed heat-generating resistors, whereby dye is transferred from the selectively heated regions of the dye-donor element to the receiver sheet and forms a pattern thereon, the shape and density of which are in accordance with the pattern and intensity of heat applied to the dye-donor element.

A dye-donor element for use according to thermal dye sublimation transfer usually comprises a very thin support e.g. a polyester support, one side of which is covered with a dye layer comprising the printing dyes. Usually, an adhesive or subbing layer is provided between the support and the dye layer. Normally, the opposite side is covered with a slipping layer that provides a lubricated surface against which the thermal printing head can pass without suffering abrasion. An adhesive layer may be provided between the support and the slipping layer.

The dye element can be a monochromic dye layer or it may comprise sequential repeating areas of differently coloured dyes e.g. dyes having a cyan, magenta, yellow, and optionally black heu. When a dye-donor element containing three or more primary color dyes is used, a multicolour image can be obtained by sequentially performing the dye transfer process steps for each colour.

A primary coloured dye layer e.g. a magenta or cyan or yellow dye layer may comprise only one primary coloured dye (a magenta, cyan or yellow dye respectively) or may comprise a mixture or two or more primary colour dyes of the same hue (two magenta, two cyan or two yellow dyes respectively).

Any dye can be used in such a dye layer provided it is easily transferable to the dye-image-receiving layer of the receiver sheeet or element by the action of heat.

Typical and specific examples of dyes for use in thermal dye sublimation transfer have been described in e.g. EP 209,990, EP 209,991, EP 216,483, EP 218,398, EP 227,095, EP 227, 096, EP 229,374, EP 235,939, EP 247,737, EP 257,577, EP 257,580, EP 258,856, EP 400,706, EP 279,330, EP 279,467, EP 285,665, US 4,743,582, US 4,753,922, US 4,753,923, US 4,757,046, US 4,769,360,US 4,771,035, US 5,026,677, JP 84/78,894, JP 84/78,895, JP 84/78,896, JP 84/227,490, JP 84/227,948, JP 85/27,594, JP 85/30,391, JP 85/229,787, JP 85/229,789, JP 85/229,790, JP 85/229,791, JP 85/229,792, JP 85/229,793, JP 85/229,795, JP 86/41,596, JP 86/268,493, JP 86/268,494, JP 86/268,495 and JP 86/284,489.

However, by forming full colour dye images using a dye donor element comprising a repeating sequence of differently colored dye layers (generally primary colored) arranged in a predetermined order according to the above described method, the following problem arises.

In an image recording process for printing an image that consists of at least two primary colors on a receiving sheet, the image is separated in its composing (primary) color separations. These different primary color separations are then printed over each other using for each color separation the corresponding colored dye layer of the dye donor element. For example, if a full color image is to be printed, at least the primary colors yellow, magenta and cyan are generally used. Accordingly, the full color image will be separated in a yellow, magenta and cyan color separations. In recording the full color image, the first primary color separation, generally the yellow part of the image, is printed on the receiving sheet using a yellow colored dye layer comprising one or more yellow dyes. Subsequently, the magenta and cyan color separations are printed on top of the printed yellow part of the image using respectively the magenta and cyan colored dye layers. However, when printing a further color separation on a previously recorded color separation, dye printed in that previously printed part of the image partially transfer back from the receiving sheet to the dye donor element. For example, when recording first a yellow image and subsequently magenta and cyan, yellow dye will be transferred back to the dye donor element when recording the magenta part of the iamge and again when printing the cyan part of the image. Similarly, magenta dye will transfer back during printing of the cyan part of the image on the prerecorded magenta parts of the image. This phenomenon is called inverse transfer or retransfer. This problem may cause falls color renderings and/or reduce color depth of the image.

The problem is most pronounced when printing black images or in black areas of a full color image since yellow dye may retransfer in at least two subsequent printing passes, i.e. when printing magenta and cyan. As a result, the amount of yellow dye in the image will be too low and as a consequence the absorption in the blue part of the spectrum will be too low. Accordingly, the black image will not appear as neutral black but rather as a blueish black image. This problem is further amplified in full color image when highly spectrally pure magenta and cyan dyes are used having little side absorptions in the blue part of the spectrum to render brilliant appearing full color images.

Further, to reduce the blueish black appearance of a black image or black image-areas, the amount of the other primary dyes magenta and cyan need to be lowered resulting in a lower overall density of black.

In JP-01-120392 the problem is addressed by adjusting the dye/binder ratio and by using binders in which the dye is less soluble. However, this solution increases the risk for dye crystallisation in the donor element and may reduce the stability thereof.

In WO 94/04369 a solution is proposed wherein the retransfer is compensated for by side absorption of dyes transferred in a subsequent printing pass. However, as explained above, this method is not preferred for rendering brilliant full color images.

### 3. Summary of the invention

It is therefore an object of the present invention to provide a solution to the phenomenon of retransfer so that a more neutral black and/or brilliant appearing full color image may be obtained in a thermal sublimation transfer recording process.

Further objects of the present invention will become clear from the description hereinafter.

Accordingly, the present invention provides a method for reproducing an image according to thermal dye sublimation transfer printing by printing two or more color separations of said image on top of each other, said method comprising in the order given the steps of:
(i) forming a first assemblage by bringing a dye donor layer into face-to-face relationship with a receiving layer comprised on a support of a receiving element, said dye donor layer having a color and comprising a dye;
(ii) image-wise heating said first assemblage thereby transferring said dye to said receiving layer in accordance with an amount of heat supplied and rendering a first color separation of said image;
(iii) separating said dye donor layer from said receiving layer;
(iv) forming at least one other assemblage by bringing a further dye donor layer into face-to-face relationship with said receiving layer of said receiving element, said further dye donor layer having a color different from a color of a dye donor layer used in any other assemblage and comprising a dye;
(v) image-wise heating said other assemblage thereby transferring said dye to said receiving layer in accordance with an amount of heat supplied and rendering a further color separation of said image;
said method being characterised in that a component A and B are brought in reactive association during image-wise heating of said other assemblage, said component A and B thereby forming a color of similar hue as a previously rendered color separation of said image.

The present invention further provides a dye donor element comprising a repeating sequence of at least two dye donor layers having different colors and each comprising a dye, said dye donor layers being arranged side by side for printing in a predetermined order, one of said dye donor layers comprising a component A and a dye donor layer subsequent in said predetermined order comprising a component B, said components A and B when brought in reactive association with each other forming a color similar in hue as a color of a dye donor layer being located earlier in said predetermined order relative to said dye donor layer comprising component B.

The present invention also provides a thermal imaging system for use in thermal dye sublimation transfer printing comprising a dye donor element and a receiving element, said dye donor element comprising a repeating sequence of at least two dye donor layers having different colors and each comprising a dye, said dye donor layers being arranged side by side for printing in a predetermined order and one of said dye donor layers arranged in said repeating sequence for printing subsequent to one or more other dye donor layers comprising a component A, said receiving element comprising on a support a receiving layer containing a component B uniformly distributed therein, said components A and B when brought in reactive association forming a color similar in hue as a color of a dye donor layer arranged previous in said predetermined order relative to said dye donor layer comprising component A.

### 4. Detailed description of the invention

Components A and B for use in the present invention are compounds that are preferably colorless or that may be slightly colored. When brought in reactive association, components A and B form a color and/or the color density is increased. Preferably, one of components A and B is a dye precursor and the other is a reagent so that upon reaction a dye is formed. Different mechanisms of color formation may be employed. For example the reaction of A and B may result in a spectral shift from the UV-part of the spectrum into the visual part, an increase of the molar extinction coefficient may be obtained, or an entirely new chromophoric system may be formed.

Dye precursors suitable for use in connection with the present invention are disclosed in e.g. US 4.011.352, US 3.957.288, US 3.488.013, US 3.663.257, US 3.390.995, US 5.011.811 and US 3.992.140.

Reagents for use in combination with a dye precursor for forming a color dye can be of various chemical nature according to the particular dye precursor choosen. For example, a color dye may be formed using an acid/base reaction, a redox reaction, an electrophile/coupler reaction etc. between the dye precursor and the reagent. Reagents suitable for use in this invention are disclosed in e.g. US 3.911.171, US 3.390.995 and US 5.011.811.

According to a particularly preferred embodiment in connection with the present invention, a colored dye is formed by bringing an organic acid and a dye precursor according to one of the following formulas into reactive association:

X-Ar-CH=N-R¹ (I)

wherein Ar represents a bivalent aromatic nucleus, R¹ represents an aryl group, e.g. phenyl or naphtyl, and X represents an amino group, in particular NR²R³ wherein each of R² and R³ independently represents an alkyl group, an alkenyl group, an alkynyl group, an aryl group or R² and R³ together with the nitrogen atom to which they are attached represents the necessary atoms to form a heterocyclic ring; 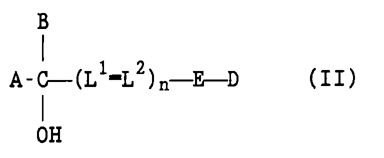 wherein A, B and D each independently represents an aryl or heterocyclic ring, B can also represent a hydrogen or can jointly with A form the remaining members of a heterocyclic ring, E represents a direct bond or a 〉N-alkyl group, L¹ and L² each independently represents a methine group optionally substituted by an alkyl, nitrile or alkoxycarbonyl or represents a N atom and n denotes 0 or 1. In a particular preferred embodiment, A and B jointly represent the remaining necessary atoms to form an indoline ring.

Examples of dye precursors according to formula (I) are:

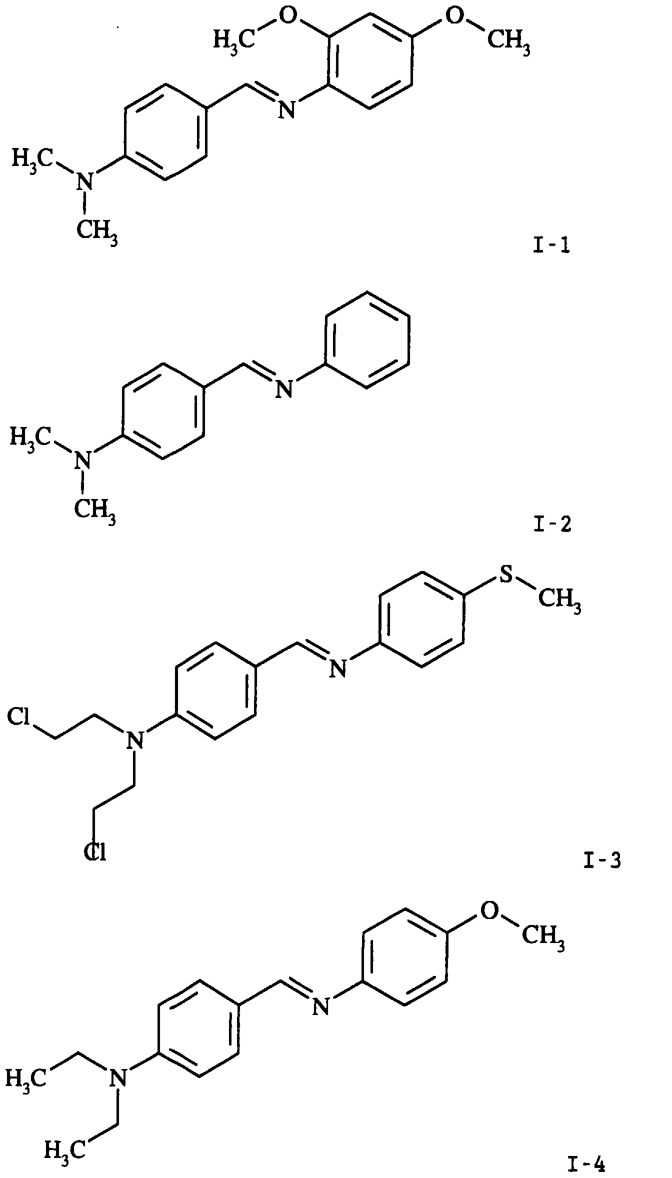

Further examples according to formula (I) are shown in US 4.011.352.

Examples according to formula (II) are:

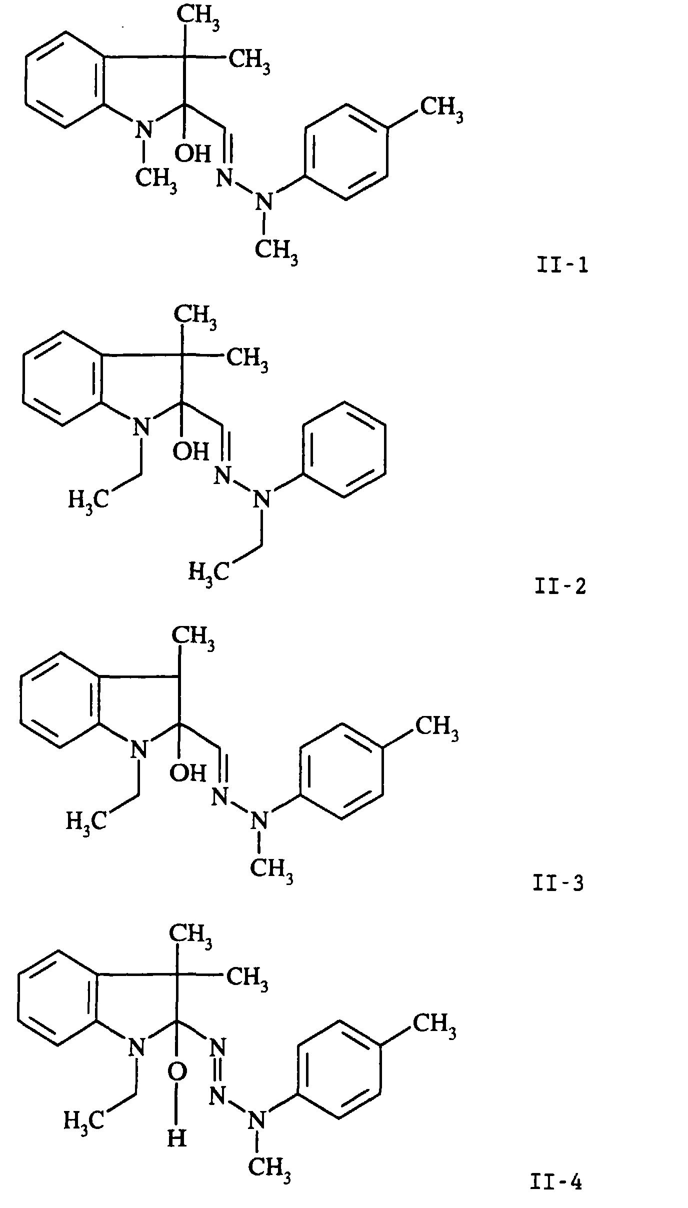

Further examples of compounds according to formula (II) are disclosed in US 3.992.140.

The components A and B may be brought in reactive association in various ways. For example components A and B may be provided in different primary colored dye donor layers of the dye donor element. According to a highly preferred embodiment, component A is provided in the first dye layer to be used in the printing sequence and component B is provided in at least one of the subsequently used dye layers in the printing process. According to a particularly preferred embodiment in connection with the present invention, a dye donor element comprises three different primary colored dye layers, i.e. yellow, magenta and cyan (in that order), arranged side-wise in a repeating sequence on a single support or as separate dye layers on three supports one of these dye layers containing component A and at least one other containing component B.

In a highly preferred embodiment, component A is provided in the yellow dye layer and component B is provided in the magenta and/or cyan dye layer and components A and B forming a yellow dye when brought in reactive association. Thus according to the printing method set out above, a full color image can be rendered with the dye donor element according to this embodiment by first printing the yellow part of the image whereby component A is transferred to the receiving sheet together with the yellow dye. Subsequently, the magenta part of the image is printed and magenta dye is transferred together with component B if provided in the magenta dye layer. At areas of the receiver sheet that contain yellow image parts that are overprinted with magenta (rendering a red color) yellow dye retransfers to the donor element. If the magenta dye layer contains component B, this retransfer is compensated by the transfer of component B which brings component B in reactive association with component A and as a consequence a yellow dye is formed. Finally, the receiver sheet is printed with the cyan part of the image. Again retransfer of yellow dye may occur which may be compensated for if the cyan dye layer contains component B. It will also be understood that retransfer of magenta dye may occur when printing the cyan image part. This is generally not so sever as the retransfer of yellow dye, however, it may likewise be compensated for by providing a component A in the magenta dye layer and a component B in the cyan dye layer whereby components A and B form a magenta color upon reaction.

In accordance with the present invention, a dye donor element may have a further black colored dye layer in addition to yellow, magenta and cyan. Since this black layer is generally used last in the printing sequence, it is preferred to provide a component A in the yellow dye layer and a component B in the black dye layer whereby both components form a yellow dye upon reaction. A component B is preferably also provided in the magenta and/or cyan dye frame. Further, a component A of a magenta forming couple may be provided in the magenta part and the B component of that couple may be provided in the cyan and/or black dye layer. A component A of a cyan forming couple can be provided in the cyan dye layer and the B component can be provided in the black dye layer although such is generally not necessary since the sensitivity of the human eye to red is not so high.

Instead of or in addition to the use of both components A and B in different dye layers of a dye donor element as described above, one of the components can be provided in a dye layer of a dye donor element and the other can be uniformly distributed in a receiving layer of a receiving element. For example, in a component system A-B that can yield a yellow colored dye, one of the components can be provided in a receiving layer of a receiving element and the other can be provided in at least one dye layer that is used to print subsequent to the printing of a yellow dye layer. Thus in a dye donor element comprising a yellow, magenta and cyan dye layer for printing in the given order, one of the components is included in a receiving layer of a receiving sheet and the other is included in the magenta and/or cyan dye layer. Similarly, a component A of a magenta forming couple can be provided in the cyan dye layer while the B component of the couple is present in the receiving layer.

According to the most preferred embodiment however, the components A and B are both contained in the donor element with the receiving layer being substantially free of the components A and B. Although retransfer can be compensated for when including one of the components in the receiving layer and the other in a dye layer of the donor element, this mode leads to less brilliant colors than in case both components are in the donor element. Thus, in case a component A for a yellow forming dye is contained in the magenta dye layer and the component B is included in the receiving layer, yellow dye will also be formed at places in the image where only magenta is needed leading to less pure magenta and blue (combination of magenta and cyan) colors in the image. Nevertheless, this embodiment may be useful in cases where only a slight compensation of retransfer is needed.

In accordance with the present invention and in particular in the above embodiments it is preferred to use as a component A a dye precursor and as component B the reagent, e.g. an organic acid. If more than one color forming couple A-B is used, e.g. a yellow and magenta forming couple, one of the components may be shared between the couples. In particular, different dye precursors can be used with a common reagent to yield different colors.

A dye donor element for use in the present invention comprises at least two differently colored dye layers that are either side by side arranged in a repeating sequence on a single support or that are each provided on different supports.

The dye layer is formed preferably by adding the dyes, components A and/or B, the polymeric binder medium, and other optional components to a suitable solvent or solvent mixture, dissolving or dispersing the ingredients to form a coating composition that is applied to a support, which may have been provided first with an adhesive or subbing layer, and dried.

The dye layer thus formed has a thickness of about 0.2 to 5.0 µm, preferably 0.4 to 2.0 µm, and the amount ratio of dye to binder ranges from 9:1 to 1:3 by weight, preferably from 2:1 to 1:2 by weight.

As polymeric binder the following can be used : cellulose derivatives, such as ethyl cellulose, hydroxyethyl cellulose, ethylhydroxy cellulose, ethylhydroxyethyl cellulose, hydroxypropyl cellulose, methyl cellulose, cellulose nitrate, cellulose acetate formate, cellulose acetate hydrogen phthalate, cellulose acetate, cellulose acetate propionate, cellulose acetate butyrate, cellulose acetate pentanoate, cellulose acetate benzoate, cellulose triacetate; vinyl-type resins and derivatives, such as polyvinyl alcohol, polyvinyl acetate, polyvinyl butyral, copolyvinyl butyral-vinyl acetal-vinyl alcohol, polyvinyl pyrrolidone, polyvinyl acetoacetal, polyacrylamide; polymers and copolymers derived from acrylates and acrylate derivatives, such as polyacrylic acid, polymethyl methacrylate and styrene-acrylate copolymers; polyester resins; polycarbonates; copolystyrene-acrylonitrile; polysulfones; polyphenylene oxide; organosilicones, such as polysiloxanes; epoxy resins and natural resins, such as gum arabic. Preferably, the binder for the dye layer of the present invention comprises cellulose acetate butyrate of copolystyrene-acrylonitrile.

The components A and B in accordance with the present invention may be used in admixture with known dyes for thermal sublimation printing. In particular they can be used in combination with tricyano- and dicyanovinyl dyes as disclosed in EP 92203566, EP 92203208 and with malononitrile dimer derived dyes as disclosed in EP-A-400706. The present systems components A and B may also be used in admixture with azo dyes e.g. disperse azo dyes, anthraquinone dyes, indoaniline dyes, azomethine dyes. Examples of dyes that can be used in the present invention are disclosed in e.g. EP 92203979, EP 209,990, EP 209,991, EP 216,483, EP 218,397, EP 227,095, EP 227,096, EP 229,374, EP 235,939, EP 247,737, EP 257,577, EP 257,580, EP 258,856, EP 279,330, EP 279,467, EP 285,665, EP 400,706, US 4,743,582, US 4,753,922, US 4,753,923, US 4,757,046, US 4,769,360, US 4,771,035, US 5,026,677, JP 84/78,894, JP 84/78,895, JP 84/78,896, JP 84/227,490, JP 84/227,948, JP 85/27,594, JP 85/30,391, JP 85/229,787, JP 85/229,789, JP 85/229,790, JP 85/229,791, JP 85/229,792, JP 85/229,793, JP 85/229,795, JP 86/41,596, JP 86/268,493, JP 86/268,494, JP 86/268,495, and JP 86/284,489, US 4,839,336, US 5,168,094, US 5,147,844, US 5,177,052, US 5,175,069, US 5,155,088, US 5,166,124, US 5,166,129, US 5,166,128, US 5,134,115, US 1,132,276, US 1,132,275, US 5, 132,274, US 5,132,273, US 5,132,268, US 5,132,267, US 5,126,314, US 5,126,313, US 5,126,312, US 5,126,311, US 5,134,116, US 4,975,410, US 4,885,272, US 4,886,029, etc..

The coating layer may also contain other additives, such as curing agents, preservatives, organic or inorganic fine particles, dispersing agents, antistatic agents, defoaming agents, viscosity-controlling agents, these and other ingredients have been described more fully in EP 133,011, EP 133,012, EP 111,004, and EP 279,467.

Any material can be used as the support for the dye-donor element provided it is dimensionally stable and capable of withstanding the temperatures involved, up to 400°C over a period of up to 20 msec, and is yet thin enough to transmit heat applied on one side through to the dye on the other side to effect transfer to the receiver sheet within such short periods, typically from 1 to 10 msec. Such materials include polyesters such as polyethylene terephthalate, polyamides, polyacrylates, polycarbonates, cellulose esters, fluorinated polymers, polyethers, polyacetals, polyolefins, polyimides, glassine paper and condenser paper. Preference is given to a support comprising polyethylene terephthalate. In general, the support has a thickness of 2 to 30 µm. The support may also be coated with an adhesive or subbing layer, if desired.

The dye layers of the dye-donor element may be coated on a support or printed thereon by a printing technique such as a gravure process.

A dye barrier layer comprising a hydrophilic polymer may also be employed between the support and the dye layer of the dye-donor element to enhance the dye transfer densities by preventing wrong-way transfer of dye backwards to the support. The dye barrier layer may contain any hydrophilic material that is useful for the intended purpose. In general, good results have been obtained with gelatin, polyacrylamide, polyisopropyl acrylamide, butyl methacrylate-grafted gelatin, ethyl methacrylate-grafted gelatin, ethyl acrlate-grafted gelatin, cellulose monoacetate, methylcellulose, polyvinyl alcohol, polyethyleneimine, polyacrylic acid, a mixture of polyvinyl alcohol and polyvinyl acetate, a mixture of polyvinyl alcohol and polyacrylic acid, or a mixture of cellulose monoacetate and polyacrylic acid. Suitable dye barrier layers have been described in e.g. EP 227091 and EP 228065. Certain hydrophilic polymers, e.g. those described in EP 227091, also have an adequate adhesion to the support and the dye layer, so that the need for a separate adhesive or subbing layer is avoided. These particular hydrophilic polymers used in a single layer in the dye-donor element thus perform a dual function, hence are referred to as dye-barrier/subbing layers.

Preferably the reverse side of the dye-donor element has been coated with a slipping layer to prevent the printing head from sticking to the dye-donor element. Such a slipping layer would comprise a lubricating material such as a surface active agent, a liquid lubricant, a solid lubricant or mixtures thereof, with or without a polymeric binder. The surface-active agents may be any agents known in the art such as carboxylates, sulfonates, phosphates, aliphatic amine salts, aliphatic quaternary ammonium salts, polyoxyethylene alkyl ethers, polyethylene glycol fatty acid esters, fluoroalkyl C2-C20 aliphatic acids. Examples of liquid lubricants include silicone oils, synthetic oils, saturated hydrocarbons and glycols. Examples of solid lubricants include various higher alcohols such as stearyl alcohol, fatty acids and fatty acid esters. Suitable slipping layers have been described in e.g. EP 138483, EP 227090, US 4567113, US 4572860, US 4717711. Preferably the slipping layer comprises a styrene-acrylonitrile copolymer or a styrene-acrylonitrile-butadiene copolymer or a mixture thereof or a polycarbonate as described in EP-A-527520 as binder and a polysiloxane-polyether copolymer or polytetrafluoroethylene or a mixture thereof as lubicrant in an amount of 0.1 to 10% by weight of the binder or binder mixture.

The support for the receiver sheet that for use in combination with the dye-donor element may be a transparant film of e.g. polyethylene terephthalate, a polyether sulfone, a polyimide, a cellulose ester or a polyvinyl alcohol-co-acetal. The support may also be a reflective one such as baryta-coated paper, polyethylene-coated paper or white polyester i.e. white-pigmented polyester. Blue-colored polyethylene terephthalate film can also be used as support.

To avoid poor adsorption of the transferred dye to the support of the receiver sheet or receiver element this support must be coated with a special surface, a dye-image-receiving layer, into which the dye can diffuse more readily. The dye-image-receiving layer may comprise, e.g. a polycarbonate, a polyurethane, a polyester, a polyamide, polyvinyl chloride, polystyrene-co-acrylonitrile, polycaprolactone or mixtures thereof. The dye-image receiving layer may also comprise a heat-cured product of poly(vinylchloride/co-vinylacetate/co-vinylalcohol) and polyisocyanate. Suitable dye-receiving layers have been described in e.g. EP 133011, EP 133012, EP 144247, EP 227094, EP 228066.

In order to improve the light-fastness and other stabilities of recorded images, UV absorbers, singlet oxygen quenchers such as HALS-compounds (Hindered Amine Light Stabilizers) and/or antioxidants can be incorporated into the receiving layer.

The dye layer of the dye-donor element or the dye-image-receiving layer of the receiver sheet may also contain a releasing agent that aids in separating the dye-donor element from the receiving sheet after transfer. The releasing agents can also be incorporated in a separate layer on at least part of the dye layer and/or of the dye-image-receiving layer. Suitable releasing agents are solid waxes, fluorine- or phosphate-containing surface-active agents and silicone oils. Suitable releasing agents have been described in e.g. EP 133012, JP 85/19138 and EP 227092.

The dye-donor elements according to the invention are used to form a dye transfer image, which process comprises placing the dye layer of the dye-donor element in face-to-face relation with the dye--image-receiving layer of the receiver sheet or receiver element and image-wise heating, e.g. by a thermal head from the back of the dye-donor element. The transfer of the dye can be accomplished by heating for about several milliseconds (5-40ms) at a temperature of 400°C.

In addition to thermal heads, laser light, infrared flash or heated pens can be used as the heat source for supplying heat energy. Thermal printing heads that can be used to transfer dye from the dye-donor elements of the present invention to a receiver sheet are commercially available. In case laser light is used, the dye layer or another layer of the dye element has to contain a compound that absorbs the light emitted by the laser and converts it into heat e.g. carbon black.

Alternatively, the support of the dye-donor element may be an electrically resistive ribbon consisting of e.g. a multilayer structure of a carbon loaded polycarbonate coated with a thin aluminum film. Current is injected into the resistive ribbon by electrically adressing a printing head electrode resulting in highly localized heating of the ribbon beneath the relevant electrode. The fact that in this case the heat is generated directly in the resistive ribbon and that it is thus the ribbon that gets hot leads to an inherent advantage in printing speed using the resistive ribbon/electrode head technology compared to the thermal head technology, according to which the various elements of the thermal head get hot and must cool down before the head can move to the next printing position.

The following examples illustrate the invention in more detail without limiting, however, the scope thereof.

### Examples

### Receiving Sheets

As receiving sheets are used the commercially available Agfa Drystar™ acceptors :
- DRYSTAR™ TS 20 -: Opaque film
- DRYSTAR™ TS 2C -: Clear Base film

### Dye Donor Elements

Dye-donor elements for use with the above described receiving elements according to thermal dye sublimation transfer were prepared as follows :

A solution in methyl ethyl ketone of 0,5 % by weight of poly(styrene-co-acrylonitrile) (Luran 388S, supplied by BASF Germany) as a binder and the dye, colour precursor and/or reagent, in the amount of mg/10 ml methyl ethylketone indicated in tables 1 and 2 was prepared.

A dye layer having a wet thickness of 100 µm was coated from this solution on a polyethylene terephthalate film support having a thickness of 6 µm and carrying a conventional subbing layer. The resulting dye layer was dried by evaporation of the solvent.

The opposite side of the film support was coated with a subbing layer of a copolyester comprising ethylene glycol, adipic acid, neopenty glycol, therephthalic acid, isophthalic acid and glycerol.

The resulting subbing layer was covered with a solution in methyl ethyl ketone of 0.5 g/m² of a polycarbonate to form a heat-resistant layer

Finally, a top layer of polyether-modified polydimethylsiloxane (Tegoglide 410, Goldschmidt) was coated from a solution in isopropanol on the resulting heat-resistant polycarbonate layer.

The dye-donor elements were printed in combination with the above described receiver sheets in a Mitsubishi colour video printer CP100E.

The receiver sheet was separated from the dye-donor element and the colour density value of the recorded image was measured by means of a Macbeth TR 924 densitometer in the red, green, and blue regions in Status A mode.

The chemical structure of the dyes was as follows:

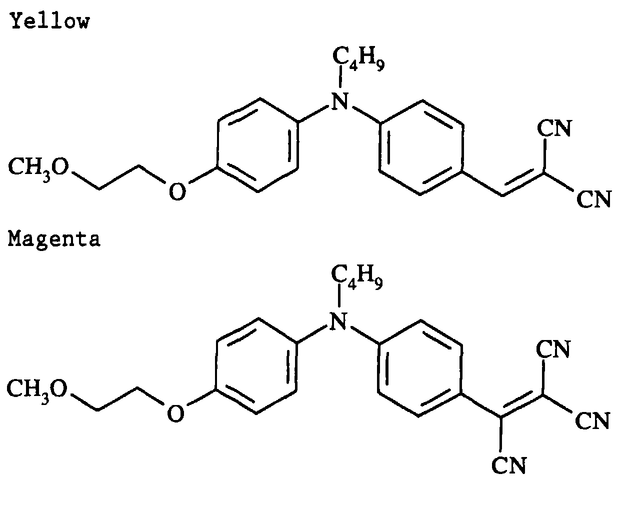

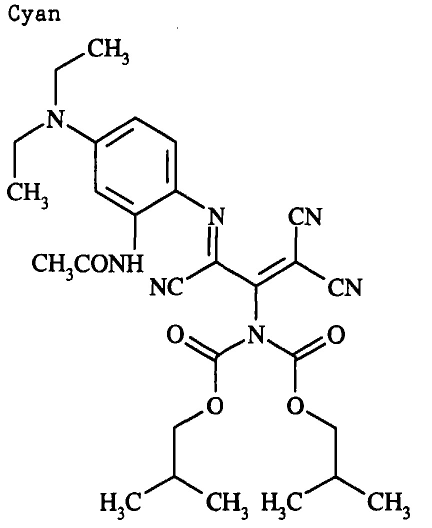

As a reagent the following component AC was used:

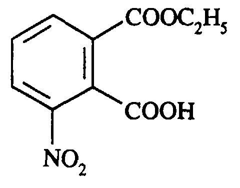

As a color precursor compounds I-1 and II-1 mentioned above were used.

### Example 1

Increase in colour density of the colour precursors, after contacting with the reagent on the receiving element.

The donor elements indicated in Table 1 were prepared according to the above described methods.

**Table 1**

| Material No. | 1 | 2 | 3 | 4 | 5 | 6 |
|---|---|---|---|---|---|---|
| cyan | 50mg | | | | | |
| magenta | | 50mg | | | | |
| yellow | | | 50mg | | | |
| acid | | | | 50mg | | |
| II-1 | | | | | 50mg | |
| I-1 | | | | | | 50mg |

Table 2 gives the colour (yellow) densities of the precursors after printing as such on Drystar TS 20, and after printing the reagent on it in a second pass, measured in the blue absorption in transmission.

**Table 2**

| Material No. | Blue absorption |
|---|---|
| 5 | 51 |
| 5 + 4 | 238 |
| 6 | 18 |
| 6 + 4 | 172 |

As can be seen from Table 2 a substantial increase in density is possible in a second pass by using a colorless reagent.

### Example 2

Three colour materials with correction for loss of yellow density in black, red and green caused by retransfer of the first printed colours.

In this example colour printing was done using the three dye layers (materials 1-3) as described in Example 1, Table 1.

The amounts of optionally used supplementary additives are indicated in the Tables 3 and 4. The concentration is given in mg/10 ml methyl ethylketone coating solution. The colour precursor are always mixed in the yellow dye layer, the reagent (AC) in the magenta, cyan or both dye layers as indicated in the Tables. Table 3 gives the obtained densities on DRYSTAR TS 20 opaque receiver, Table 4 on DRYSTAR TS 2C clear film receiver.

As can be seen from the Tables 3 and 4, it is possible to increase the yellow densities in the blacks, reds and greens in a broad range, even beyond the density of the original yellow selection where no retransfer has happened.

**Table 3**

| Sample no. | comp. II-1 (mg) | comp. I-1 (mg) | AC added to magenta (mg) | AC added to cyan (mg) | Dₘₐₓ Yellow measured in | | | |
|---|---|---|---|---|---|---|---|---|
| | | | | | Black | red | green | selection |
| 3-1 | | | | | 197 | 235 | 230 | 248 |
| 3-2 | | | 20 | | 177 | 216 | 219 | 242 |
| 3-3 | | | 40 | | 178 | 219 | 233 | 255 |
| 3-4 | 25 | | | | 207 | 236 | 236 | 257 |
| 3-5 | 50 | | | | 193 | 235 | 221 | 243 |
| 3-6 | | 25 | | | 224 | 251 | 250 | 272 |
| 3-7 | | 50 | | | 230 | 267 | 252 | 275 |
| 3-8 | 25 | | 20 | | 260 | 290 | 240 | 258 |
| 3-9 | 50 | | 20 | | 279 | 306 | 220 | 239 |
| 3-10 | | 25 | 20 | | 247 | 299 | 262 | 264 |
| 3-11 | | 50 | 20 | | 277 | 316 | 259 | 270 |
| 3-12 | 25 | | 40 | | 252 | 294 | 249 | 263 |
| 3-13 | 50 | | 40 | | 305 | 343 | 245 | 255 |
| 3-14 | | 25 | 40 | | 261 | 306 | 264 | 280 |
| 3-15 | | 50 | 40 | | 306 | 335 | 266 | 285 |
| 3-16 | | | | | 197 | 235 | 230 | 248 |
| 3-17 | | | | 20 | 188 | 230 | 223 | 249 |
| 3-18 | | | | 40 | 185 | 236 | 220 | 253 |
| 3-19 | | | 20 | 20 | 182 | 226 | 226 | 254 |
| 3-20 | 25 | | | 20 | 239 | 242 | 274 | 256 |
| 3-21 | 50 | | | 20 | 256 | 230 | 282 | 246 |
| 3-22 | | 25 | | 20 | 252 | 263 | 276 | 276 |
| 3-23 | | 50 | | 20 | 283 | 273 | 291 | 277 |
| 3-24 | 25 | | | 40 | 233 | 236 | 284 | 263 |
| 3-25 | 50 | | | 40 | 263 | 238 | 311 | 248 |
| 3-26 | | 25 | | 40 | 265 | 269 | 288 | 281 |
| 3-27 | | 50 | | 40 | 289 | 271 | 305 | 279 |
| 3-28 | 25 | | 20 | 20 | 256 | 308 | 283 | 255 |
| 3-29 | 50 | | 20 | 20 | 289 | 303 | 294 | 264 |
| 3-30 | | 25 | 20 | 20 | 246 | 288 | 265 | 275 |
| 3-31 | | 50 | 20 | 20 | 247 | 268 | 280 | 277 |

**Table 4**

| Sample no. | comp. II-1 (mg) | comp. I-1 (mg) | AC added to magenta (mg) | AC added to cyan (mg) | Dₘₐₓ Yellow measured in | | | |
|---|---|---|---|---|---|---|---|---|
| | | | | | Black | red | green | selection |
| 4-1 | | | | | 193 | 185 | 190 | 246 |
| 4-2 | | | 20 | | 187 | 154 | 217 | 266 |
| 4-3 | | | 40 | | 191 | 153 | 220 | 272 |
| 4-4 | 25 | | | | 208 | 202 | 209 | 251 |
| 4-5 | 50 | | | | 201 | 201 | 204 | 245 |
| 4-6 | | 25 | | | 208 | 187 | 223 | 281 |
| 4-7 | | 50 | | | 210 | 194 | 223 | 275 |
| 4-8 | 25 | | 20 | | 258 | 207 | 220 | 268 |
| 4-9 | 50 | | 20 | | 289 | 240 | 208 | 246 |
| 4-10 | | 25 | 20 | | 230 | 209 | 226 | 268 |
| 4-11 | | 50 | 20 | | 280 | 251 | 226 | 270 |
| 4-12 | 25 | | 40 | | 265 | 222 | 230 | 262 |
| 4-13 | 50 | | 40 | | 283 | 251 | 217 | 245 |
| 4-14 | | 25 | 40 | | 255 | 218 | 224 | 274 |
| 4-15 | | 50 | 40 | | 273 | 249 | 228 | 265 |
| 4-16 | | | | | 193 | 185 | 190 | 246 |
| 4-17 | | | | 20 | 197 | 167 | 216 | 256 |
| 4-18 | | | | 40 | 196 | 164 | 210 | 274 |
| 4-19 | | | 20 | 20 | 207 | 170 | 222 | 271 |
| 4-20 | 25 | | | 20 | 224 | 179 | 253 | 254 |
| 4-21 | 50 | | | 20 | 258 | 180 | 270 | 243 |
| 4-22 | | 25 | | 20 | 267 | 191 | 261 | 280 |
| 4-23 | | 50 | | 20 | 264 | 207 | 268 | 260 |
| 4-24 | 25 | | | 40 | 244 | 182 | 264 | 274 |
| 4-25 | 50 | | | 40 | 268 | 176 | 283 | 250 |
| 4-26 | | 25 | | 40 | 292 | 202 | 245 | 271 |
| 4-27 | | 50 | | 40 | 260 | 206 | 289 | 269 |
| 4-28 | 25 | | 20 | 20 | 258 | 218 | 264 | 269 |
| 4-29 | 50 | | 20 | 20 | 287 | 256 | 275 | 249 |
| 4-30 | | 25 | 20 | 20 | 257 | 232 | 266 | 278 |
| 4-31 | | 50 | 20 | 20 | 308 | 269 | 282 | 268 |

## Claims

1. A method for reproducing an image according to thermal dye sublimation transfer printing by printing two or more color separations of said image on top of each other, said method comprising in the order given the steps of:
(i) forming a first assemblage by bringing a dye donor layer into face-to-face relationship with a receiving layer comprised on a support of a receiving element, said dye donor layer having a color and comprising a dye;
(ii) image-wise heating said first assemblage thereby transferring said dye to said receiving layer in accordance with an amount of heat supplied and rendering a first color separation of said image;
(iii) separating said dye donor layer from said receiving layer;
(iv) forming at least one other assemblage by bringing a further dye donor layer into face-to-face relationship with said receiving layer of said receiving element, said further dye donor layer having a primary color different from a color of a dye donor layer used in any other assemblage and comprising a dye;
(v) image-wise heating said other assemblage thereby transferring said dye to said receiving layer in accordance with an amount of heat supplied and rendering a further color separation of said image;
said method being characterised in that a component A and B are brought in reactive association during image-wise heating of said other assemblage, said component A and B thereby forming a color of similar hue as a previously rendered color separation of said image.

2. A method according to claim 1 wherein component A is comprised in one dye donor layer and component B is comprised in at least one other dye donor layer.

3. A method according to claim 1 wherein component A is comprised in a dye donor layer and component B is uniformly distributed throughout said receiving layer.

4. A method according to claim 1 wherein at least a yellow, magenta and cyan color separation are printed in the order given and said yellow color separation being printed using a yellow colored dye donor layer comprising a dye and component A, said magenta and cyan color separations being printed with a magenta respectively cyan colored dye donor layer and at least one of said magenta and cyan colored dye donor layer comprising a component B, said component A and B forming a yellow dye when brought in reactive association.

5. A method according to claim 4 wherein a further black color separation is printed with a black colored dye donor layer, said black colored dye donor layer optionally comprising a component B.

6. A method according to any of the above claims wherein said one of said components A and B is a dye precursor and the other is a reagent that when brought in reactive association form a dye.

7. A method according to any of the above claims wherein one of said components A and B is an organic acid and the other is a dye precursor corresponding to one of the following formulas:
X-Ar-CH=N-R¹ (I)
wherein Ar represents a bivalent aromatic nucleus, R¹ represents an aryl group, and X represents an amino group; 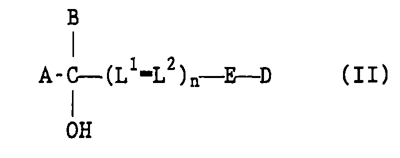 wherein A, B and D each independently represents an aryl or heterocyclic ring, B can also represent a hydrogen or can jointly with A form the remaining members of a heterocyclic ring, E represents a direct bond or a 〉N-alkyl group, L¹ and L² each independently represents a methine group optionally substituted by an alkyl, nitrile or alkoxycarbonyl or represents a N atom and n denotes 0 or 1.

8. A dye donor element comprising a repeating sequence of at least two dye donor layers having different colors and each comprising a dye, said dye donor layers being arranged side by side for printing in a predetermined order, one of said dye donor layers comprising a component A and a dye donor layer subsequent in said predetermined order comprising a component B, said components A and B when brought in reactive association with each other forming a color similar in hue as a color of a dye donor layer being located earlier in said predetermined order relative to said dye donor layer comprising component B.

9. A dye donor element according to claim 8 wherein said dye donor layers are arranged on a single support.

10. A dye donor element according to any of claims 8 or 9 comprising at least a yellow, magenta and cyan colored dye donor layer arranged in that order.

11. A dye donor element according to claim 10 wherein said yellow colored dye donor layer comprises a component A.

12. A dye donor element according to claim 11 further comprising a component B in said magenta and/or cyan colored dye donor layer and wherein said component A and B are capable of forming a yellow colored dye when brought in reactive association.

13. A dye donor element according to any of claims 10 to 12 further comprising a black colored dye donor layer optionally comprising a component B.

14. A dye donor element according to any of claims 8 to 13 wherein one of said components A and B is an organic acid and the other is a dye precursor corresponding to one of the following formulas:
X-Ar-CH=N-R¹ (I)
wherein Ar represents a bivalent aromatic nucleus, R¹ represents an aryl group, and X represents an amino group; 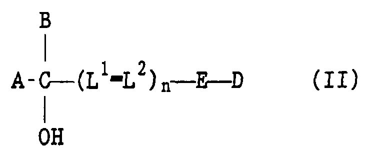 wherein A, B and D each independently represents an aryl or heterocyclic ring, B can also represent a hydrogen or can jointly with A form the remaining members of a heterocyclic ring, E represents a direct bond or a 〉N-alkyl group, L¹ and L² each independently represents a methine group optionally substituted by an alkyl, nitrile or alkoxycarbonyl or represents a N atom and n denotes 0 or 1.

15. A thermal imaging system for use in thermal dye sublimation transfer printing comprising a dye donor element and a receiving element, said dye donor element comprising a repeating sequence of at least two dye donor layers having different colors and each comprising a dye, said dye donor layers being arranged side by side for printing in a predetermined order and one of said dye donor layers arranged in said repeating sequence for printing subsequent to one or more other dye donor layers comprising a component A, said receiving element comprising on a support a receiving layer containing a component B uniformly distributed therein, said components A and B when brought in reactive association forming a color similar in hue as a color of a dye donor layer arranged previous in said predetermined order relative to said dye donor layer comprising component A.

16. A thermal imaging system according to claim 15 wherein said component A is comprised in a yellow colored dye donor layer and said components A and B forming a yellow dye when brought into reactive association.

17. A thermal imaging system according to claim 15 wherein said dye donor layers are arranged on a single support.

18. A thermal imaging system according to any of claims 15 to 17 wherein said dye donor element comprises at least a yellow, magenta and cyan colored dye donor layer arranged in that order.

19. A thermal imaging system according to claim 18 wherein said dye donor element further comprises a black colored dye donor layer.

20. A thermal imaging system according to any of claims 18 or 19 wherein said yellow colored dye donor layer comprises component A and at least one of said magenta, cyan and/or black colored dye donor layers comprises a component B.

21. A thermal imaging system according to any of claims 15 to 20 wherein one of said components A and B is an organic acid and the other is a dye precursor corresponding to one of the following formulas:
X-Ar-CH=N-R¹ (I)
wherein Ar represents a bivalent aromatic nucleus, R¹ represents an aryl group, and X represents an amino group; 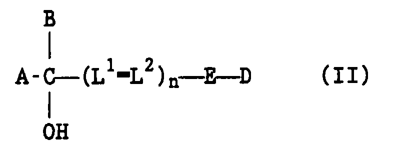 wherein A, B and D each independently represents an aryl or heterocyclic ring, B can also represent a hydrogen or can jointly with A form the remaining members of a heterocyclic ring, E represents a direct bond or a 〉N-alkyl group, L¹ and L² each independently represents a methine group optionally substituted by an alkyl, nitrile or alkoxycarbonyl or represents a N atom and n denotes 0 or 1.
